# EUROPÄISCHE PATENTSCHRIFT

(11) **EP 1 574 864 B1**
(45) Veröffentlichungstag und Bekanntmachung des Hinweises auf die Patenterteilung: **07.05.2008**
(21) Anmeldenummer: 05003555.9
(22) Anmeldetag: 18.02.2005
(51) Int. Cl.: G01R 31/00, G07C 5/08

(54) **Verfahren zum Testen der Funktion von in einem Kraftfahrzeug eines bestimmten Typs verbauten, über einen Kommunikationsbus adressierbaren elektronischen und elektrischen Komponenten**
Method for testing of the function of electronic and electric components mounted in a vehicle of a specific type and addressable via a communication bus
Procédé permettant de tester le fonctionnement des composants électroniques et électriques intégrés dans un véhicule d'un type donné et adressables par un bus de communication

(30) Priorität: 12.03.2004 DE 102004012143
(43) Veröffentlichungstag der Anmeldung: 14.09.2005
(73) Patentinhaber: AUDI AG, 85045 Ingolstadt (DE)
(72) Erfinder: Hondyk, Marc, 85055 Ingolstadt (DE); Erb, Matthias, 71672 Marbach (DE)
(74) Vertreter: Thielmann, Frank

(56) Entgegenhaltungen:
- DE-A1- 10 032 080
- DE-A1- 10 236 620
- DE-A1- 19 857 462
- US-A- 5 041 976
- US-B1- 6 233 509

## Beschreibung

Die Erfindung betrifft ein Verfahren zum Testen der Funktion von in einem Kraftfahrzeug eines bestimmten Typs verbauten, über einen Kommunikationsbus adressierbaren elektronischen und elektrischen Komponenten.

Die Komplexität des Fahrzeugelektriksystems steigt zunehmend, nachdem fahrzeugseitig immer mehr Funktionalitäten, die elektronisch angesteuert werden oder Signale liefern, vorgesehen werden. Dies zeigt sich insbesondere in der steigenden Zahl separater Steuergeräte, die unterschiedliche Komplexe steuern. In der Regel sind die elektrischen oder elektronischen Komponenten über einen zentralen Fahrzeugbus, z. B. CAN-Bus miteinander verbunden, so dass sie direkt angesprochen werden können, aber auch untereinander kommunizieren und Daten oder Signale austauschen können. Nachdem ein solches System in gewisser Weise fehleranfällig ist, ist es erforderlich, diverse Tests durchzuführen, um das einwandfreie Funktionieren zu überprüfen, um also zu sehen, inwieweit die in das Bussystem integrierten Gerätschaften miteinander kommunizieren, Daten aufnehmen oder auf den Bus geben, etc.

Eine Prüfung zu verbauender Komponenten findet jedoch insbesondere in der Serienproduktion nur sehr beschränkt statt. In der Regel werden zu verbauende Komponenten an separaten Prüfstationen vor der eigentliche Montage auf ihre Funktion überprüft. Zu nennen sind beispielsweise Motorprüfstände, auf denen der fertige Kraftfahrzeugmotor vor seinem eigentlichen Einbau in die Karosserie getestet wird. Ein solches Testverfahren ist z. B. aus DE 198 57 462 A1 bekannt. Bei diesem Verfahren wird ein an einem CAN-Bus angeschlossener Testmotor in verschiedenen Betriebszuständen betrieben und die dabei auftretenden Datensignale der mit einer zu prüfenden Einzelkomponente kommunizierenden Steuergeräte abgespeichert. Diese an einem separaten Teststand aufgenommenen Daten dienen als Datenbasis der Umgebung für einen später zu testenden Kraftfahrzeugmotor an einem separaten Motorenprüfstand. Es erfolgt also lediglich eine "Inselprüfung" einzelner, separater Komponenten vor dem eigentlichen Verbau. Soweit ein Test nach der Herstellung des Fahrzeugs vorgenommen wird, beschränkt sich dieser nur auf eine sehr kurze Testfahrt von wenigen Kilometern, im Rahmen welcher übliche Tests wie z. B. ein Bremsentest, ein Schalttest, ein Lichttest und Ähnliches vorgenommen wird. Eine dynamische Prüfung von Situationen, wie sie im Alltagsbetrieb auftreten und wie sie zu bestimmten Signalen, erzeugt von irgendwelchen Sensoren, Aktoren oder Steuergeräten etc. auf den Kommunikationsbus führen, ist nicht möglich.

DE 100 32 080 A1 beschreibt ein Verfahren und ein Prüfgerät zur Einbaukontrolle von elektrischen Komponenten in einem Kraftfahrzeug. Diese Komponenten werden an einen Kommunikationsbus angeschlossen. Das Prüfgerät überträgt einen Satz von Eingangssignalen and die zu prüfende elektrische Komponente und erfasst die Ist-Ausgangssignale und vergleicht diese mit Soll-Ausgangssignalen.

DE 198 57 462 A1 beschreibt ein Verfahren zur Prüfung von Einzelkomponenten eines Kraftfahrzeugs. Die Testeinrichtung ist dazu vorgesehen, Messdaten des komplexen Gesamtsystems in der Umgebung der zu prüfenden Einzelkomponente während des Betriebs auf einem Prüfstand zu erfassen, abzuspeichern und später als Prüfsignale wieder zu generieren.

Der Erfindung liegt damit das Problem zugrunde, ein Verfahren anzugeben, das einen Funktionstest einer Vielzahl verbauter elektronischer und elektrischer Komponenten und deren Zusammenwirken unter möglichst realen Prüfbedingungen ermöglicht.

Zur Lösung dieses Problems ist bei einem Verfahren der eingangs genannten Art erfindungsgemäß vorgesehen, dass zum Test ein typenspezifischer Realdatensatz verwendet wird, dessen Realdaten bei realen Fahrten eines Kraftfahrzeugs des gleichen Typs wie das zu testende aufgenommen wurden, wobei die Realdaten auf den Kommunikationsbus gegeben werden und die von den angesprochenen Komponenten als Reaktion auf die Realdaten auf den Kommunikationsbus gegebenen Reaktionsdaten erfasst werden, die als Ist-Daten mit den Soll-Daten darstellenden Realdaten verglichen werden und anhand des Vergleichs die Funktion der überprüfbaren Komponenten bestimmt wird, und/oder die als Reaktion auf die auf den Kommunikationsbus gegebenen Realdaten in komponentenseitige Speichereinrichtungen eingetragenen Fehlerspeicherdaten ausgelesen und zur Bestimmung der Funktion der überprüften Komponenten ausgewertet werden.

Basis für das erfindungsgemäße Verfahren ist die Erfassung von Daten aus beliebig durchgeführten realen Straßenfahrten mit einem Fahrzeug des gleichen Typs, vornehmlich mit einer maximalen Ausstattung an elektrischen und elektronischen Komponenten. Die Daten werden vom Kommunikationsbus abgegriffen, das heißt, es wird während der Straßenfahrt die gesamte Datenkommunikation auf dem Bus erfasst. Bei diesen Daten handelt es sich um beliebige Daten. Sie können von in das elektronische System eingebundenen Sensoren, die Messwerte liefern und auf den Bus geben, von Steuergeräten, die eine bestimmte Information auf den Bus geben oder die auf ein bestimmtes gegebenes Signal ein Reaktionssignal auf den Bus geben, oder beliebigen anderen Komponenten stammen. Diese Daten werden auf Basis realer Vorkommnisse während der Fahrt erzeugt. Wird beispielsweise während der Fahrt die Klimaanlage zugeschalten, wird ein entsprechendes Signal auf den Bus gegeben, das dazu führt, dass das Klimasteuergerät entsprechend tätig wird, und seinerseits wiederum Signale auf den Bus gibt, um entsprechende Aktoren oder dergleichen anzusteuern. Greift das ABS-System, detektieren also die Radsensoren entsprechende Bedingungen, werden ebenfalls entsprechende auslösende Signale auf den Bus gegeben, die von einem Steuergerät zu Reaktionssignalen verarbeitet werden, die wiederum auf den Bus gegeben werden und ihrerseits zu anderen Reaktionssignalen führen. Es wird also der gesamte Datentrafic auf dem Bus aufgenommen. Dieser Realdatensatz bildet die Testdatenbasis für nachfolgende Tests.

Im Rahmen dieser Tests werden die aufgenommenen Realdaten, die z. B. bei einer Testfahrt von 60 Minuten oder länger aufgenommen wurden, auf den Bus gegeben, wobei die Daten bezogen auf ihre Aufnahmedauer zeitlich komprimiert, jedoch eindeutig zeitaufgelöst auf den Bus gegeben werden. Diese Daten sind nun Grundlage für eine entsprechende Kommunikation der tatsächlichen Verbauten Gerätschaften und Komponenten über den Kommunikationsbus. Ein innerhalb der Realdaten enthaltenes Sensorsignal eines Sensors, das auch innerhalb der Realdaten zu einer Reaktion seitens eines Steuersignals in Form eines Reaktionssignals führt, führt auch im zu prüfenden Kraftfahrzeug im Idealfall zur gleichen Reaktion des Steuergeräts, das heißt, es müsste innerhalb der aufgenommenen Testdaten ein identisches Reaktionssignal des Steuergeräts vorliegen. Führt ein Signal, das innerhalb der Realdaten von einem Steuergerät an ein anderes gegeben wird, zu einem Reaktionssignal dieses Steuergeräts, müsste im Idealfall dieses Reaktionssignal identisch innerhalb der aufgenommenen Testdaten des zu überprüfenden Fahrzeugs abgebildet werden.

Innerhalb des erfindungsgemäßen Verfahrens werden nun parallel zur Gabe der Realdaten die entsprechenden Kommunikationsdaten des Busses des zu prüfenden Fahrzeugs aufgenommen. Diese quasi eine Reaktion auf die auslösenden Realdaten darstellenden Reaktionsdaten bilden den Ist-Datensatz, der mit dem Soll-Datensatz, gebildet vom Realdatensatz, verglichen wird. Ist das zu prüfende Fahrzeug ausstattungsmäßig identisch mit dem Fahrzeug, an dem die Realdaten aufgenommen wurden, müsste im Idealfall auch eine Identität zwischen den Ist-Daten und den Soll-Daten vorliegen. Sofern die Ausstattung nicht identisch ist und das zu prüfende Fahrzeug geringer ausgestattet ist, ergibt sich insofern eine Datendiskrepanz, als diverse Steuergeräte, weil nicht vorhanden, nicht reagieren können. Dies führt aber insofern nicht zu Schwierigkeiten, als im Rahmen des Vergleichs die Ausstattungsvariante berücksichtigt wird und der Realdatensatz vornehmlich mit einem Fahrzeug mit maximaler Ausstattung aufgenommen wird. Alternativ oder zusätzlich zur Auswertung der Reaktionsdaten ist auch eine Analyse der auf Basis der eingespeisten typenspezifischen Realdaten erzeugten und in komponentenseitigen Speichern, z. B. Steuergerätespeichern, abgelegten Fehlerspeicherdaten, die ausgelesen werden, möglich. Hier erfolgt also der Vergleich der Ist-Daten mit Soll-Zuständen oder Soll-Daten auf Basis einer Analyse der Fehlerspeichereinträge.

Insgesamt lässt das erfindungsgemäße Verfahren also die Funktion und das Zusammenwirken verbauter Komponente auf Basis realer Prüfszenarien zu. Die Prüfungstiefe ist also wesentlich größer als bei der bisher bekannten separaten Prüfung einzelner Komponenten im nicht verbauten Zustand.

Die Realdaten sind zweckmäßigerweise um bei ihrer Aufnahme im Rahmen der realen Fahrten entstandenen Fehlerdaten bereinigt, um zu vermeiden, dass fehlerhafte Testdaten auf den Bus des zu prüfenden Fahrzeugs gegeben werden.

Zur Ermöglichung der Zuordnung eines Reaktionsdatums zu seinem im Rahmen des Vergleichs gegenüberzustellenden Realdatum sind die Realdaten zweckmäßigerweise wie bereits beschrieben zeitaufgelöst, das heißt, es kann zu jedem beispielsweise eine bestimmte zeitlich verzögerte Reaktion erfordernden Realdatum das entsprechende Reaktionsdatum zugeordnet werden, so dass geprüft werden kann, ob beispielsweise ein über ein Realdatum angesprochenes Steuergerät auch tatsächlich auf dieses Datum geantwortet hat, also das Reaktionsdatum auf den Bus gegeben hat. Das heißt, die Realdaten sind mit einem Zeitstempel versehen, der eine entsprechende Abbildung und Zuordnung der Reaktionsdaten zu den Realdaten im Rahmen des Ist-Soll-Datenvergleichs ermöglicht.

Die Reaktionsdaten werden während der Gabe der Realdaten zweckmäßigerweise laufend erfasst und auch kontinuierlich mit den Realdaten verglichen, so dass am Ende des Testzyklus äußerst zeitnah die Auswertung beendet werden kann. Wie beschrieben werden zweckmäßigerweise die Realdaten in einer im Vergleich zur Geschwindigkeit oder Zeitdauer ihrer realen Aufnahme höheren Geschwindigkeit oder kürzeren Zeit auf den Kommunikationsbus gegeben, wobei dabei etwaige Reaktionszeiten der Steuergeräte des zu prüfenden Fahrzeugs beachtet werden müssen, um sicherzustellen, dass ein angesprochenes Steuergerät auch tatsächlich hat reagieren können. Alternativ zu den Realdaten können auch die Einträge der Fehlerspeicher der Steuergeräte für die Analyse/Prüfung des elektrischen/elektronischen Systems genutzt werden. Dazu werden die Fehlerspeichereinträge innerhalb der Finish-Linie ausgelesen.

Nach einer ersten Erfindungsalternative kann ein Funktionstest nach Fertigstellung des Kraftfahrzeugs, wenn dieses also vollständig zusammengebaut ist und alle Komponenten integriert sind, durchgeführt werden. Es würde also innerhalb und/oder am Ende der Finish-Linie eine Teststation vorgesehen werden, in der das Kraftfahrzeug getestet wird. Dieser Test kann z. B. 5 Minuten in Anspruch nehmen, je nachdem wie schnell die Realdaten auf den Bus gegeben werden können und die Ist-Daten aufgezeichnet und ausgewertet werden können.

Alternativ - aber auch zusätzlich während des Zusammenbaus - kann der Funktionstest auch während des Zusammenbaus mehrmals durchgeführt werden, das heißt, dass das Kraftfahrzeug während des Zusammenbaus z. B. intermittierend oder nach Verbau bestimmter Komponenten oder dergleichen geprüft wird. Im Rahmen dieses Funktionstests werden zweckmäßigerweise alle Realdaten auf den Kommunikationsbus gegeben. Diejenigen Realdaten, zu denen bereits beispielsweise entsprechende Steuergeräte und dergleichen verbaut wurden, die also ihren Adressaten finden können, kommen an und werden entsprechend bearbeitet bzw. behandelt, während Realdaten betreffend Komponenten, die noch nicht verbaut sind, nicht stören, da sie keinen Adressaten finden.

Zur Gabe der Realdaten und zur Aufnahme der Reaktionsdaten wird besonders vorteilhaft ein mobiles, tragbares Datenverarbeitungsgerät verwendet, das mit dem Kommunikationsbus verbunden wird, egal ob nun der Funktionstest am Ende oder während des Zusammenbaus durchgeführt wird. Ein solches Datenverarbeitungsgerät verbleibt bei einem Mehrfach-Test während des Zusammenbaus zweckmäßigerweise während der ganzen Zeit am Fahrzeug und zeichnet alle im Rahmen der währenddessen durchgeführten Funktionstests anfallenden Reaktionsdaten geordnet auf. Die Funktionstests können, wenn das Fahrzeug während des Zusammenbaus mehrfach getestet wird, wie beschrieben entweder zu vorgegebenen Zeitpunkten oder bei Erreichen einer vorbestimmten Zusammenbaustufe durchgeführt werden. Hierzu werden gegebenenfalls automatisch bestimmte Komponenten auf ihr Vorhandensein erfasst. Ergibt sich, dass z. B. das gesamte Armaturenbrett mit all seinen Steuergeräten und sonstigen Komponenten eingesetzt wurde, kann dieses beispielsweise ein entsprechendes Signal auf den Bus geben, das seitens des Datenverarbeitungsgeräts erfasst wird und so den Funktionstest anstößt.

Wie bereits beschrieben enthalten die Realdaten auch Daten von oder betreffend Komponenten, die zumindest im Testzeitpunkt nicht verbaut sind. Diese Daten finden, wenn sie auf den Bus gegeben werden, keinen Adressaten, lösen also keine Reaktion aus, sind aber für den sonstigen Funktionstest nicht hinderlich. Dies hat den Vorteil, dass keine verschiedenen Realdatensätze für unterschiedliche Prüfzeitpunkte, insbesondere bei einer Testung an der Linie, vorgehalten werden müssen.

Im Rahmen der Aufnahme der Reaktionsdaten werden vorteilhaft nicht nur Kommunikationsdaten auf dem Kommunikationsbus aufgenommen, sondern auch etwaige Einträge in Fehlerspeicher von Komponenten, insbesondere der Steuergeräte ausgelesen und aufgenommen, was ebenfalls für die Auswertung von Vorteil ist.

Der Realdatensatz enthält vorteilhaft Realdaten bezogen auf einen typenspezifischen maximalen Verbaugrad an elektronischen oder elektrischen Komponenten, was dahingehend von Vorteil ist, als im Idealfall lediglich ein einziger typenspezifischer Realdatensatz vorrätig gehalten werden muss, nachdem darin enthaltene "Überschussdaten" betreffend nicht verbaute Komponenten etc. nicht störend sind.

Um das erfindungsgemäße Verfahren möglichst flexibel auszugestalten ist vorgesehen, in dem zum Funktionstest verwendeten, gegebenenfalls tragbaren Datenverarbeitungsgerät mehrere typenspezifische Realdatensätze für verschiedene Kraftfahrzeugtypen abzulegen, wobei der zu verwendende Realdatensatz in Abhängigkeit des zu prüfenden Fahrzeugs ausgewählt wird. Das heißt, es sind für verschiedene Fahrzeugtypen spezifische Sätze vorhanden, wobei der zu verwendende Realdatensatz zum gegebenen Zeitpunkt ausgewählt und eingelesen wird. Weiterhin kann vorgesehen sein, dass in dem zum Funktionstest verwendeten, gegebenenfalls tragbaren Datenverarbeitungsgerät mehrere typenspezifische Realdatensätze für verschiedene Ausstattungsvarianten des Kraftfahrzeugs abgelegt sind, wobei der zu verwendende Realdatensatz in Abhängigkeit des zu prüfenden Kraftfahrzeugs ausgewählt wird. Es erfolgt gemäß dieser Erfindungsausgestaltung auch eine zusätzliche Variantenspezifizierung. Das heißt, zu einem Fahrzeugtyp sind beispielsweise drei variantenspezifische Datensätze vorgesehen, eine Maximalvariante, eine mittlere Variante und eine Minimalvariante. Je nachdem, welcher Variante der tatsächliche Verbaugrad des zu prüfenden Kraftfahrzeugs am nächsten kommt, wird der entsprechende Datensatz ausgewählt.

Schließlich kann vorgesehen sein, dass in dem zum Funktionstest verwendeten, gegebenenfalls tragbaren Datenverarbeitungsgerät mehrere länderspezifische Realdatensätze abgelegt sind, wobei der zu verwendende Realdatensatz in Abhängigkeit des zu prüfenden Kraftfahrzeugs ausgewählt wird. Diese Erfindungsausgestaltung trägt dem Umstand Rechnung, dass die realen Fahrbedingungen mitunter auch von dem Land, in das das Kraftfahrzeug geliefert werden soll, abhängig sind. Ein Kraftfahrzeug, das in eine sehr heiße Klimazone geliefert wird, ist anderen realen Bedingungen ausgesetzt, als ein Kraftfahrzeug, das nach Skandinavien oder noch nördlicher geliefert wird. Wenn entsprechende Realdaten auf Testfahrten zu derartigen unterschiedlichen Bedingungen aufgenommen wurden, so können dementsprechend noch spezifischere Tests durchgeführt werden.

Eine besonders vorteilhafte Weiterbildung des Erfindungsgedankens sieht vor, dass die Datensatzauswahl anhand einer den Kraftfahrzeugtyp und gegebenenfalls die Ausstattungsvariante und gegebenenfalls das Einsatzland angebenden Information betreffend den Produktionsvorgang des Kraftfahrzeugs oder anhand einer vom Kraftfahrzeug gegebenen oder erfassten Identifikationsnummer erfolgt. Nähere Informationen bezüglich des zu testenden Kraftfahrzeugs ergeben sich aus dem Produktionsvorgang selbst, nachdem zu jedem Zeitpunkt bekannt ist, welches Kraftfahrzeug welche Ausstattung enthält (was ja zwangsläufig für den Produktionsvorgang und die Teilezufuhr etc. erforderlich ist), und wohin das Kraftfahrzeug geliefert wird. Alternativ ist es auch denkbar, während des Anschließens des Datenverarbeitungsgeräts über dieses eine Fahrzeugidentifikationsnummer auszulesen und so sämtliche Informationen, die für die Auswahl des Realdatensatzes erforderlich sind, aufzunehmen.

Neben der Möglichkeit, mehrere Realdatensätze auswählbar im Datenverarbeitungsgerät abzulegen und diese bei Bedarf auszuwählen, sieht eine Erfindungsalternative vor, dass der zu verwendende Realdatensatz in dem zu verwendenden Datenverarbeitungsgerät zeitnah abgespeichert wird. Auch diese Erfindungsalternative setzt auf der genauen Kenntnis des Fahrzeugstyps, der Ausstattungsvariante und gegebenenfalls seines länderspezifischen Einsatzort auf. Gelangt also ein zu prüfendes Fahrzeug in den Testbereich (egal ob dies während des Zusammenbaus oder am Ende desselben erfolgt), so sind sämtliche fahrzeugspezifischen Daten bekannt. Als weitere Möglichkeit ist denkbar, dass die Daten über Netzwerke und drahtlose Übertragung jeweils von einem Server direkt (Online) über ein entsprechendes Gerät ins Fahrzeug übertragen werden. Eine Zwischenspeicherung der Daten kann in diesem Fall entfallen.

Der Vergleich der Ist-Daten mit den Soll-Daten kann dabei in dem Datenverarbeitungsgerät selbst oder in einer separaten Recheneinrichtung, der die vom Datenverarbeitungsgerät aufgenommenen Ist-Daten und gegebenenfalls auch die Soll-Daten gegeben werden, erfolgen. Die Soll-Daten können seitens dieser externen Recheneinrichtung auch bereits vorliegen. Die Recheneinrichtung benötigt dann lediglich eine Information betreffend den zu verwendenden Soll-Datensatz, welche Information vom Datenverarbeitungsgerät selbst übergeben werden kann. Auf der anderen Seite ist es denkbar, dass die Recheneinrichtung alle Informationen zum zu testenden Fahrzeug kennt, und anhand dieser selbst den richtigen Soll-Datensatz auswählen kann.

Um eine schnelle Erfassung etwaiger Fehler oder Fehlfunktionen vorzunehmen wird zweckmäßigerweise anhand des Vergleichsergebnisses ein Testbericht erstellt und ausgegeben. Dies kann schriftlich erfolgen, um Dokumentationsunterlagen vorzuhalten, kann aber auch rein elektronisch durch Ausgabe an einen Terminal oder dergleichen erfolgen, oder durch Ausgabe der Fehlerspeichereinträge über die installierten Prüfsysteme.

Ersichtlich bietet das erfindungsgemäße Verfahren eine Reihe von Vorteilen. Zum einen können die elektronischen oder elektrischen Systeme schnell unter realen Bedingungen bzw. auf Basis realer Kommunikationsdaten geprüft werden. Reale Testfahrten können folglich auf ein Minimum reduziert werden, eine Prüfung des elektronischen Systems im Rahmen dieser Testfahrten kann weitestgehend entfallen. Eine direkte Zuordnung eines Fehlers, eines Fehlersymptoms oder einer Fehlerbeschreibung zu einem auslösenden Ereignis ist möglich, nachdem die "Auslösedaten", also die Realdaten zeitaufgelöst auf den Bus gegeben werden. Auch ist eine beliebige Kombinierbarkeit von Betriebszuständen aus beispielsweise verschiedenen realen Straßenfahrten möglich, nachdem die separaten Realdaten zu einem Gesamt-Datensatz kombiniert werden können. Das heißt, es können unterschiedliche Daten beispielsweise aus einer Regenfahrt, einer Eis- oder Schneefahrt sowie einer Trockenfahrt und beispielsweise einer Fahrt bei extrem heißen Bedingungen zu einem Gesamtdatenpool zusammengestellt werden, die einem Test zugrunde gelegt werden. Auch ist eine wesentlich schnellere Prüfung im Vergleich zur Durchführung einer Straßenfahrt denkbar, wie auch eine Auswertung des Soll-Ist-Vergleichs zu einem sehr plausiblen und fundierten Prüfungsergebnis führt. Das Verfahren ermöglicht eine 100%-Prüfung von Fahrzeugen innerhalb bzw. am Ende der Montagelinie.

Neben dem erfindungsgemäßen Verfahren betrifft die Erfindung ferner eine Einrichtung zum Testen von in einem Kraftfahrzeug verbauten elektronischen oder elektrischen Komponenten, ausgebildet zur Durchführung des beschriebenen Verfahrens.

Weitere Vorteile, Merkmale und Einzelheiten der Erfindung ergeben sich aus dem im folgenden beschriebenen Ausführungsbeispiel sowie anhand der Zeichnungen. Dabei zeigen:

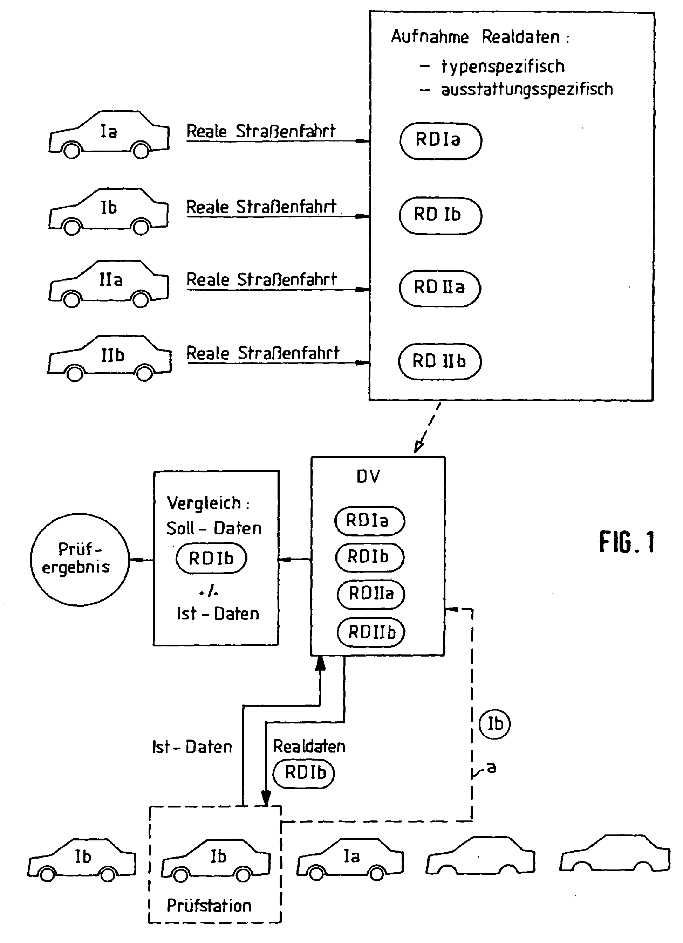

- Fig. 1: eine Prinzipdarstellung zur Beschreibung des erfindungsgemäßen Verfahrens nach einer ersten Ausführungsvariante,
- Fig. 1: eine Prinzipdarstellung mit exemplarisch angedeutetem Kommunikationsbus und verschiedenen Komponenten, und
- Fig. 3: eine Prinzipdarstellung zur Erläuterung des erfindungsgemäßen Verfahrens nach einer zweiten Ausführungsform.

Fig. 1 zeigt in Form einer Prinzipskizze die zentralen Verfahrensschritte des erfindungsgemäßen Verfahrens. Wie aus Fig. 1 ersichtlich werden zunächst unter Verwendung verschiedener fertig gestellter Kraftfahrzeuge unterschiedlichen Typs und unterschiedlicher Fahrzeugausstattung reale Straßenfahrten vorgenommen, um verschiedene Realdatensätze aufzunehmen, die typen- und ausstattungsspezifisch sind. Im gezeigten Beispiel werden exemplarisch zwei verschiedene Kraftfahrzeugtypen verwendet, nämlich die Kraftfahrzeuge vom Typ I und die Kraftfahrzeuge vom Typ II. Innerhalb der verschiedenen Typen werden zwei unterschiedliche Ausstattungsvarianten eingesetzt, nämlich eine minimale Ausstattungsvariante a und eine maximale Ausstattungsvariante b. In der minimalen Ausstattungsvariante a ist eine bestimmte Anzahl oder sind bestimmte Arten von elektrischen oder elektronischen Komponenten, jedoch nicht alle maximal verbaubaren vorgesehen, während in der maximalen Ausstattungsvariante b alle zu diesem Typ maximal verbaubaren Komponenten vorhanden sind. Es kommen also zwei unterschiedliche Fahrzeugtypen in zwei unterschiedlichen Ausstattungsvarianten zum Einsatz, nämlich die Fahrzeug la und Ib sowie die Fahrzeuge IIa und IIb.

Mit diesen Fahrzeugen werden beliebige reale Straßenfahrten durchgeführt, das heißt, zu beliebigen Zeiten, unter beliebigen Umweltbedingungen und unter Durchführung beliebiger Handlungen, wobei im Rahmen der Datengenerierung möglichst viele unterschiedliche Situationen durchgespielt werden sollen, um den Realdatensatz möglichst groß und möglichst vielseitig zu gestalten. Während der Straßenfahrten wird zu jedem Kraftfahrzeug ein Realdatensatz durch Aufnahme des gesamten Buskommunikationsverkehrs, also aller auf dem Kommunikationsbus des Kraftfahrzeugs, z. B. dem CAN-Bus vorhandener Informationen bzw. Daten aufgenommen. Im gezeigten Beispiel führt dies zu vier verschiedenen Realdatensätzen, nämlich den Realdatensätzen RDIa und RDIb für den Kraftfahrzeugtyp I und die beiden unterschiedlichen Ausstattungsvarianten a und b sowie die Realdatensätze RDIIa und RDIIb für den Kraftfahrzeugtyp II und die beiden Ausstattungsvarianten a und b.

Sind sämtliche Realdaten aufgenommen (dies kann auch im Rahmen mehrerer zu unterschiedlichen Zeiten durchgeführter Straßenfahrten erfolgen) werden diese im gezeigten Beispiel einer zentralen Datenverarbeitungseinrichtung DV gegeben, wo die Realdatensätze entsprechend abgelegt sind.

Die Datenverarbeitungseinrichtung befindet sich im gezeigten Bespiel in einer am Ende der Fahrzeugproduktionslinie befindlichen Prüfstation. In dieser befindet sich gemäß Fig. 1 ein neu zusammengebautes Kraftfahrzeug vom Typ I in einer gehobenen Ausstattungsvariante, die der maximalen Ausstattungsvariante b entspricht oder dieser nahe kommt. Wie durch den Pfeil a dargestellt, wird in der Prüfstation beispielsweise eine Fahrzeugidentifikationsnummer erfasst und an die Datenverarbeitungseinrichtung DV gegeben. Diese Identifikationsnummer zeigt an, dass es sich hierbei um ein Fahrzeug vom Typ I in einer gehobenen Ausstattungsvariante handelt, weshalb ein Maximalausstattungsdatensatz, nämlich der Realdatensatz RDIb zu Testzwecken zu verwenden ist. Im gezeigten Beispiel ist die Gabe dieser Auswahlinformation durch "Ib" am Pfeil a dargestellt. Es ist auch möglich, vom Produktionsablauf her rührende Daten zur Datensatzauswahl zu verwenden, nachdem ja zu jedem Zeitpunkt bekannt ist, um welchen Typ in welcher Ausstattung es sich bei einem beliebigen in der Produktionslinie befindlichen Fahrzeug handelt.

Erfolgte nun die Realdatensatzauswahl, so wird die Datenverarbeitungseinrichtung mit einem Kommunikationsbus des Kraftfahrzeugs, z. B. dem CAN-Bus (es kann sich auch um einen anderen Fahrzeugbus, z. B. MOST-Bus handeln) verbunden, wonach die Realdaten in zeitlich komprimierter Form auf den Kommunikationsbus gegeben werden. Zeitgleich beginnt die Datenerfassung aller auf dem Kommunikationsbus im Hinblick auf die gegebenen Realdaten, die quasi die Aktionsdaten darstellen, transportierter Daten, die seitens der Steuergeräte oder sonstiger am Bus hängender Komponenten quasi als Reaktion auf die Aktions- oder Realdaten gegeben werden. Bei den Realdaten handelt es sich um jedwedes beliebiges Datum, das zu irgendeinem Zeitpunkt während seiner Aufnahme auf den Bus transportiert wurde, seine Sensorsignale, Steuergeräteinformation etc. In entsprechender Weise handelt es sich bei den aufgenommenen Ist-Daten gleichermaßen um beliebige von am Bus hängender Komponenten erzeugter Signale, seien es Sensorsignale oder Signale und Daten von Steuergeräten, die als Antwort auf irgendwelche Realdaten generiert und auf den Bus gegeben werden. Die Realdaten sind zeitaufgelöst, so dass jedes Ist-Datum einem bestimmten "Auslöse-Realdatum" zugeordnet werden kann. Auf diese Weise kann im Rahmen der späteren Auswertung ein Bezug eines fehlerhaften oder fehlenden Ist-Datums zu seinem auslösenden Realdatum gezogen werden, woran eine Fehleranalyse erfolgen kann.

Wurden sämtliche Ist-Daten nach Gabe aller Realdaten aufgenommen, so erfolgt seitens der Datenverarbeitungseinrichtung DV ein Vergleich zwischen den Soll-Daten, gebildet vom Realdatensatz RDIb, und den aufgenommenen Ist-Daten. Zu allen Realdaten, die von Komponenten, die auch am zu prüfenden Fahrzeug vorhanden sind, gegeben wurden oder einen Bezug zu diesen haben, und die selber ein Reaktionsdatum auf ein vorher gegebenes "Auslöse-Realdatum" sind, müssen entsprechend abgebildete, quasi identische Ist-Daten innerhalb des Ist-Datenpools vorhanden sein, nachdem das "Auslöse-Realdatum" im Realdatensatz enthalten ist und auf den Bus gegeben wurde und zum identischen Ist-Reaktionsdatum führen muss. Dies wird im Rahmen des Soll-Ist-Vergleichs erfasst und ausgewertet. Realdaten von Komponenten, die am zu prüfenden Fahrzeug nicht vorhanden sind, führen zu keiner Reaktion, nachdem die Komponentenadresse am Bus des zu prüfenden Fahrzeugs nicht gefunden wird. Zu diesem findet sich zwangsläufig auch kein entsprechendes Ist-Datum, was seitens des Datenverarbeitungsgeräts DV aber erkannt wird, nachdem diesem die Ausstattung des zu prüfenden Fahrzeugs bekannt ist.

Abhängig vom Vergleichsergebnis erfolgt dann die Ausgabe des Prüfergebnisses. Funktionieren alle Steuergeräte und sonstigen Komponenten bezogen auf die Realdaten korrekt, so kann davon ausgegangen werden, dass keine Fehler im Betrieb auftreten werden. Naturgemäß kann nicht jede Situation und jede Gerätekommunikation überprüft werden, nachdem der Prüfumfang abhängig vom Datenpool der Realdaten ist. Gleichwohl kann ein relativ weiter Prüfungsumfang realisiert werden, der - sollten der Vergleich zu einem positiven Prüfbefund führen - als Grundlage für die Annahme gewertet werden kann, dass keine Schwierigkeiten im Betrieb auftreten werden.

Stellt sich jedoch heraus, dass eine Differenz zwischen Ist- und Soll-Signalen vorliegt, so kann soweit ermittelbar das auslösende Realdatensignal, zu dem z. B. kein entsprechendes Ist-Antwortsignal vorliegt, ermittelt und für eine nähere Fehlersuche entsprechende Informationen im Prüfbericht ausgegeben werden.

Im gezeigten Beispiel verlässt das gezeigte Fahrzeug vom Typ Ib die Prüfstation, wenn die Prüfung beendet ist. Anschließend fährt das nächste Fahrzeug vom Typ I in der Ausstattungsvariante a in die Prüfstation. Die Datenverarbeitungseinrichtung erhält erneut eine entsprechende Information über den zu wählenden Realdatensatz, in diesem Fall den Realdatensatz RDIa und prüft dieses Fahrzeug in entsprechender Weise.

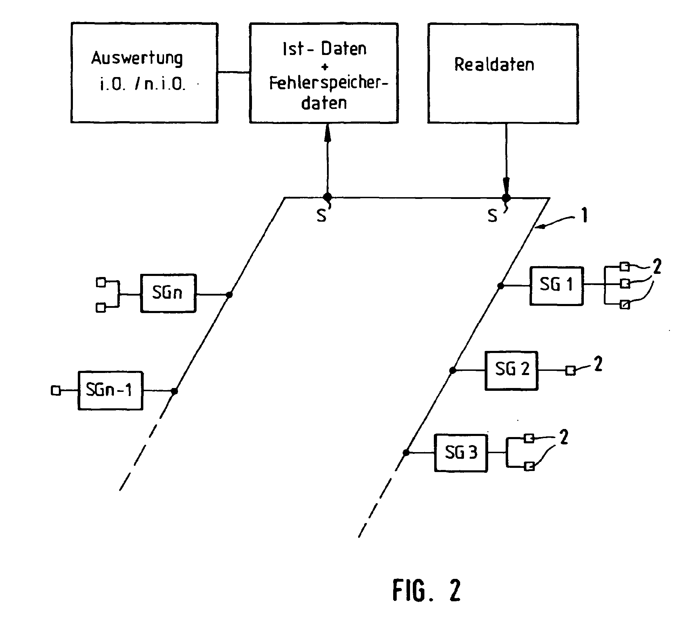

Fig. 2 zeigt in Form einer Prinzipdarstellung den Kommunikationsbus 1 eines erfindungsgemäßen Kraftfahrzeugs, an dem eine Reihe von Steuergeräten SG1, SG2, SG3, ... SGn-1, SGn vorgesehen sind, an denen eine beliebige Anzahl von Sensoren oder Aktoren 2 vorgesehen sind, die in irgendeiner Weise mit dem Steuergerät kommunizieren und Daten austauschen.

Im Rahmen des Tests werden über eine entsprechende Bus-Eingabe-Schnittstelle S bzw. einen Diagnose-Stecker, an die das Datenverarbeitungsgerät DV angeschlossen werden kann, die Realdaten auf den Kommunikationsbus 1 gegeben und dort zu den entsprechenden Steuergeräten oder Aktoren/Sensoren verteilt, die ihrerseits wiederum die Antwortsignale auf den Kommunikationsbus 1 geben, von wo sie über eine entsprechende Auslese-Schnittstelle S, die mit der Eingabe-Schnittstelle S natürlich zusammenfallen kann, ausgelesen werden. Gleichzeitig werden etwaige Fehlerspeicher der Steuergeräte ausgelesen wie auch, sofern möglich, etwaige gegebene Signale auf ihre Richtigkeit überprüft. Anschließend erfolgt die bereits beschriebene Auswertung im Rahmen des Ist-Soll-Vergleichs.

Die Realdaten sind, wie bereits beschrieben, typen- und ausstattungsspezifisch. Natürlich kann auch eine Unterscheidung zwischen verschiedenen Bus-Arten oder Bus-Systemen erfolgen, wenn am Kraftfahrzeug zwei verschiedene Busse, z. B. der CAN-BUS und der MOST-Bus vorgesehen sind. Es werden auf den jeweiligen Bus natürlich nur die bustypischen Signale gegeben.

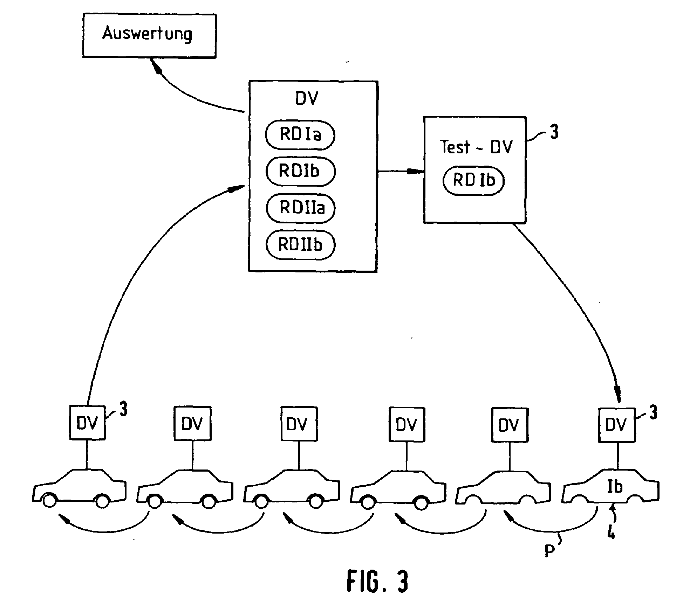

Fig. 3 zeigt eine Alternative zum beschriebenen Ausführungsbeispiel gemäß Fig. 1 mit einer zentralen, am Ende der Produktionslinie angeordneten Prüfstation. Bei dem Verfahren gemäß Fig. 3 erfolgt eine mehrfache Funktionsprüfung an der Linie während des fortschreitenden Zusammenbaus des Kraftfahrzeugs. Im gezeigten Beispiel wird fortschreitend ein Kraftfahrzeug vom Typ I in der Ausstattungsvariante b hergestellt. Dies ist der Datenverarbeitungseinrichtung DV durch entsprechende Information bekannt. In der Datenverarbeitungseinrichtung DV wird nun ein Test-Datenverarbeitungsgerät 3 mit den entsprechenden Realdatensatz RDIb, der für das Kraftfahrzeug 4 zu wählen ist, belegt, die Daten werden dort eingespeichert. Anschließend wird das Test-Datenverarbeitungsgerät 3 am Kraftfahrzeug 4 an einer geeigneten Schnittstelle S mit dem bereits installierten Kommunikationsbus 1 verbunden. Das Datenverarbeitungsgerät 3 verbleibt während des gesamten Zusammenbaus am Kraftfahrzeug. Während des fortschreitenden Zusammenbaus, dargestellt durch die jeweils fortschreitenden Pfeile P, wird zu verschiedenen Zeitpunkten, z. B. nach Einbau einer bestimmten Anzahl oder einer bestimmten Art von Steuergeräten oder dergleichen, mehrfach ein Funktionstest der bereits vorhandenen Komponenten durchgeführt. Das Datenverarbeitungsgerät 3 spielt jeweils die kompletten Realdaten am Kommunikationsbus 1 ein, nimmt die Ist-Daten auf und speichert diese zeitbezogen ab. Am Ende der Produktionsstrecke, wenn das Kraftfahrzeug 4 vollständig zusammengebaut ist, wird ein letzter Funktionstest durchgeführt, wonach das Datenverarbeitungsgerät wieder entnommen wird und der Datenverarbeitungseinrichtung DV zugeführt wird, wo die Daten ausgelesen und anschließend ausgewertet werden. Auch dies erfolgt durch Soll-Ist-Vergleich, in diesem Fall auch produktionsstufenbezogen.

Abweichend von dem in Fig. 3 beschriebenen Ausführungsbeispiel ist es natürlich auch möglich, die Auswertung durch das Datenverarbeitungsgerät 3 jeweils selber durchführen zu lassen, so dass quasi nach Entnahme am Ende der Produktionslinie zu den einzelnen Teststufen jeweils das Ergebnis vorliegt. Eine Verbindung mit der zentralen Datenverarbeitungseinrichtung DV ist dann nicht mehr erforderlich.

Auch ist es denkbar, dass sämtliche möglichen Realdatensätze bereits im Test-Datenverarbeitungsgerät 3 vorhanden sind und der zu verwendende Datensatz erst nach Verbinden des Datenverarbeitungsgeräts 3 mit dem Kraftfahrzeugbus ausgewählt wird. Hierzu liest das Datenverarbeitungsgerät z. B. eine entsprechende Identifikationsnummer des Kraftfahrzeugs aus, über welche Informationen zum Fahrzeugtyp sowie zur Ausstattungsvariante gegeben werden, wonach der zu verwendende Datensatz ausgelesen wird.

## Patentansprüche

1. Verfahren zum Testen der Funktion von in einem Kraftfahrzeug eines bestimmten Typs verbauten, über einen Kommunikationsbus adressierbaren elektronischen und elektrischen Komponenten,
**dadurch gekennzeichnet,**
**dass** zum Test ein typenspezifischer Realdatensatz verwendet wird, dessen Realdaten bei realen Straßenfahrten eines Kraftfahrzeugs des gleichen Typs wie das zu testende durch Abgreifen vom Kommunikationsbus aufgenommen wurden, wobei die Realdaten auf den Kommunikationsbus gegeben werden, und die von den angesprochenen Komponenten als Reaktion auf die Realdaten auf den Kommunikationsbus gegebenen Reaktionsdaten erfasst werden, die als Ist-Daten mit den Soll-Daten darstellenden Realdaten verglichen werden und anhand des Vergleichs die Funktion der überprüfbaren Komponenten bestimmt wird, und/oder die als Reaktion auf die auf den Kommunikationsbus gegebenen Realdaten in komponentenseitige Speichereinrichtungen eingetragenen Fehlerspeicherdaten ausgelesen und zur Bestimmung der Funktion der überprüfbaren Komponenten ausgewertet werden.

2. Verfahren nach Anspruch 1,
**dadurch gekennzeichnet,**
**dass** die Realdaten um bei ihrer Aufnahme im Rahmen der realen Fahrten entstanden Fehlerdaten bereinigt sind.

3. Verfahren nach Anspruch 1 oder 2,
**dadurch gekennzeichnet,**
**dass** zur Ermöglichung der Zuordnung eines Reaktionsdatums zu seinem im Rahmen des Vergleichs gegenüberzustellenden Realdatum die Realdaten zeitaufgelöst sind.

4. Verfahren nach einem der vorangehenden Ansprüche,
**dadurch gekennzeichnet,**
**dass** die Reaktionsdaten während der Gabe der Realdaten laufend erfasst und mit den Realdaten verglichen werden.

5. Verfahren nach einem der vorangehenden Ansprüche,
**dadurch gekennzeichnet,**
**dass** die Realdaten in einer im Vergleich zur Geschwindigkeit oder Zeitdauer ihrer realen Aufnahme höheren Geschwindigkeit oder kürzeren Zeit auf den Kommunikationsbus gegeben werden.

6. Verfahren nach einem der vorangehenden Ansprüche,
**dadurch gekennzeichnet,**
**dass** der Funktionstest nach Fertigstellung des Kraftfahrzeugs durchgeführt wird.

7. Verfahren nach einem der Ansprüche 1 bis 6,
**dadurch gekennzeichnet,**
**dass** der Funktionstest mehrmals während des Zusammenbaus des Kraftfahrzeugs durchgeführt wird.

8. Verfahren nach Anspruch 7,
**dadurch gekennzeichnet,**
**dass** im Rahmen jedes Funktionstests alle Realdaten auf den Kommunikationsbus gegeben werden.

9. Verfahren nach einem der vorangehenden Ansprüche,
**dadurch gekennzeichnet,**
**dass** zur Gabe der Realdaten und zur Aufnahme der Reaktionsdaten ein mobiles, tragbares Datenverarbeitungsgerät verwendet wird, das mit dem Kommunikationsbus verbunden wird.

10. Verfahren nach Anspruch 9,
**dadurch gekennzeichnet,**
**dass** das Datenverarbeitungsgerät während des Zusammenbaus im Kraftfahrzeug verbleibt und alle im Rahmen der währenddessen durchgeführten Funktionstest anfallenden Reaktionsdaten geordnet aufzeichnet.

11. Verfahren nach Anspruch 10,
**dadurch gekennzeichnet,**
**dass** die Funktionstests zu vorgegebenen Zeitpunkten oder bei Erreichen einer vorbestimmten Zusammenbaustufe durchgeführt werden.

12. Verfahren nach einem der vorangehenden Ansprüche,
**dadurch gekennzeichnet,**
**dass** die Realdaten auch Daten von oder betreffend Komponenten, die zumindest im Testzeitpunkt nicht verbaut sind, enthalten.

13. Verfahren nach einem der vorangehenden Ansprüche,
**dadurch gekennzeichnet,**
**dass** im Rahmen der Aufnahme der Reaktionsdaten auch etwaige Einträge in Fehlerspeicher von Komponenten, insbesondere Steuergeräten ausgelesen und aufgenommen werden.

14. Verfahren nach einem der vorangehenden Ansprüche,
**dadurch gekennzeichnet,**
**dass** der Realdatensatz Realdaten bezogen auf einen typenspezifischen maximalen Verbaugrad an elektronischen und elektrischen Komponenten enthält.

15. Verfahren nach einem der vorangehenden Ansprüche,
**dadurch gekennzeichnet,**
**dass** in dem zum Funktionstest verwendeten, gegebenenfalls tragbaren Datenverarbeitungsgerät mehrere typenspezifische Realdatensätze für verschiedene Kraftfahrzeugtypen abgelegt sind, wobei der zu verwendende Realdatensatz in Abhängigkeit des zu prüfenden Kraftfahrzeugs ausgewählt wird.

16. Verfahren nach einem der vorangehenden Ansprüche,
**dadurch gekennzeichnet,**
**dass** in dem zum Funktionstest verwendeten, gegebenenfalls tragbaren Datenverarbeitungsgerät mehrere typenspezifische Realdatensätze für verschiedene Ausstattungsvarianten des Kraftfahrzeugs abgelegt sind, wobei der zu verwendende Realdatensatz in Abhängigkeit des zu prüfenden Kraftfahrzeugs ausgewählt wird.

17. Verfahren nach einem der vorangehenden Ansprüche,
**dadurch gekennzeichnet,**
**dass** in dem zum Funktionstest verwendeten, gegebenenfalls tragbaren Datenverarbeitungsgerät mehrere länderspezifische Realdatensätze abgelegt sind, wobei der zu verwendende Realdatensatz in Abhängigkeit des zu prüfenden Kraftfahrzeugs ausgewählt wird.

18. Verfahren nach einem der Ansprüche 15 bis 17,
**dadurch gekennzeichnet,**
**dass** die Datensatzauswahl anhand einer den Kraftfahrzeugtyp und gegebenenfalls die Ausstattungsvariante und gegebenenfalls das Einsatzland angebenden Information betreffend den Produktionsvorgang des Kraftfahrzeugs oder anhand einer vom Kraftfahrzeug gegeben oder erfassten Identifikationsinformation erfolgt.

19. Verfahren nach einem der Ansprüche 1 bis 14,
**dadurch gekennzeichnet,**
**dass** der zu verwendende Realdatensatz für den oder die durchzuführenden Funktionstests in dem zu verwendenden Detenverarbeitungsgerät zeitnah eingespeichert wird.

20. Verfahren nach einem der vorangehenden Ansprüche,
**dadurch gekennzeichnet,**
**dass** der Vergleich der Ist-Daten mit den Soll-Daten in dem Datenverarbeitungsgerät selbst oder in einer separaten Recheneinrichtung, der die vom Datenverarbeitungsgerät aufgenommenen Ist-Daten und gegebenenfalls die Soll-Daten gegeben werden, erfolgt.

21. Verfahren nach einem der vorangehenden Ansprüche,
**dadurch gekennzeichnet,**
**dass** anhand des Vergleichsergebnisses ein Testbericht erstellt und ausgegeben wird.

22. Einrichtung zum Testen von in einem Kraftfahrzeug verbauten elektronischen oder elektrischen Komponenten, ausgebildet zur Durchführung des Verfahrens nach einem der Ansprüche 1 bis 21.

## Claims

1. Method for testing the function of electronic and electrical components installed in a motor vehicle of a specific type and addressable via a communication bus,
**characterized in that**
a type-specific real-data record, whose real data have been recorded over real road-journeys of a motor vehicle of the same type as that to be tested by pick-up from the communication bus, is used for the test, in the course of which the real data are loaded on to the communication bus and the reaction data of the addressed components as reaction to the real data loaded on to the communication bus are collected and compared as actual data with the real data representing should-be data, and on the basis of this comparison the function of the reviewable components is ascertained, and/or the fault-memory data recorded in component-side memory devices as reaction to the real data loaded on to the communication bus are read out and evaluated to ascertain the function of the reviewable components.

2. Method according to Claim 1,
**characterized in that**
the real data are sifted to extract fault data accrued during the recording of the real data in the course of the real journeys.

3. Method according to Claim 1 or Claim 2,
**characterized in that**
in order that a given item of reaction data can be assigned to the item of real data with which it should be compared, the real data are time-resolved.

4. Method according to any one of the preceding claims,
**characterized in that**
the reaction data are continuously collected and compared with the real data during the loading of the real data.

5. Method according to any one of the preceding claims,
**characterized in that**
the real data are loaded on to the communication bus at a higher rate (or in a shorter time) than at their real recording.

6. Method according to any one of the preceding claims,
**characterized in that**
the functional test is carried out on completion of the motor vehicle.

7. Method according to any one of Claims 1 to 6,
**characterized in that**
the functional test is carried out on several occasions during the assembly of the motor vehicle.

8. Method according to Claim 7,
**characterized in that**
all real data are loaded on to the communication bus upon every functional test.

9. Method according to any one of the preceding claims,
**characterized in that**
a mobile, portable data processing unit, connected to the communication bus, is used to load the real data and record the reaction data.

10. Method according to Claim 9,
**characterized in that**
the data processing unit stays in the motor vehicle during assembly, and records on an orderly basis all reaction data accruing in the functional test[s] carried out during this period.

11. Method according to Claim 10,
**characterized in that**
the functional tests are carried out at specific times or upon reaching a predetermined stage of assembly.

12. Method according to any one of the preceding claims,
**characterized in that**
the real data include data on or concerning components which at least at the time of testing are not installed.

13. Method according to any one of the preceding claims,
**characterized in that**
any records in fault memories of components, especially control units, are read out and recorded in the course of the recording of reaction data.

14. Method according to any one of the preceding claims,
**characterized in that**
the real-data record contains real data corresponding to a type-specific maximum panoply of installed electronic and electrical components.

15. Method according to any one of the preceding claims,
**characterized in that**
a number of type-specific real-data records for different motor-vehicle types are filed in the (optionally portable) data processing unit used for the functional test, the real-data record to be used being selected to suit the particular motor vehicle to be tested.

16. Method according to any one of the preceding claims,
**characterized in that**
a number of type-specific real-data records for different equipment-options of the motor vehicle are filed in the (optionally portable) data processing unit used for the functional test, the real-data record to be used being selected to suit the particular motor vehicle to be tested.

17. Method according to any one of the preceding claims,
**characterized in that**
a number of country-specific real-data records are filed in the (optionally portable) data processing unit used for the functional test, the real-data record to be used being selected to suit the particular motor vehicle to be tested.

18. Method according to any one of Claims 15 to 17,
**characterized in that**
selection of the data record is made on the basis of information regarding the motor-vehicle production process [and] specifying the motor-vehicle type and if applicable the equipment-option and if applicable the country of use or on the basis of identification information provided by or acquired from the motor vehicle.

19. Method according to any one of Claims 1 to 14,
**characterized in that**
the real-data record to be used in the functional test(s) to be performed is contemporaneously stored in the data processing unit to be used.

20. Method according to any one of the preceding claims,
**characterized in that**
the comparison of the actual data with should-be data is made in the data processing unit itself or in a separate computer device loaded with the actual data recorded by the data processing unit and optionally with the should-be data.

21. Method according to any one of the preceding claims,
**characterized in that**
a test report is compiled and output on the basis of the outcome of the comparison.

22. Device for testing electronic or electrical components installed in a motor vehicle, configured to carry out the method according to any one of Claims 1 to

## Revendications

1. Procédé pour tester le fonctionnement de composants électriques et électroniques, intégrés dans un véhicule d'un type défini, adressables par le biais d'un bus de communication,
**caractérisé en ce que**, pour le test est employé un jeu de données réelles, spécifique au type, dont les données réelles ont été recueillies par un prélèvement sur le bus de communication au cours de parcours routiers réels d'un véhicule du même type que celui à tester, sachant que les données réelles ont été fournies sur le bus de communication et les données de réaction, fournies sur le bus de communication par les composants adressés en tant que réaction aux données réelles, ont été collectées, lesquelles données de réaction en tant que données mesurées ont été comparées aux données réelles représentant des données théoriques et, à l'aide de la comparaison, le fonctionnement des composants vérifiables est déterminé, et/ou les données de mémoire d'erreur inscrites dans des dispositifs de mémoire au niveau des composants en tant que réaction aux données réelles fournies sur le bus de communication sont extraites et elles sont évaluées afin de déterminer le fonctionnement des composants vérifiables.

2. Procédé selon la revendication 1, **caractérisé en ce que** les données réelles sont nettoyées des données d'erreur produites lors de leur enregistrement dans le cadre des parcours réels.

3. Procédé selon la revendication 1 ou 2, **caractérisé en ce que**, pour permettre l'affectation d'une donnée de réaction à sa donnée réelle à confronter dans le cadre de la comparaison, les données réelles sont horodatées.

4. Procédé selon l'une des revendications précédentes, **caractérisé en ce que** les données de réaction sont collectées en continu durant la fourniture des données réelles et comparées aux données réelles.

5. Procédé selon l'une des revendications précédentes, **caractérisé en ce que** les données réelles sont fournies sur le bus de communication avec une vitesse plus élevée ou dans un temps plus court en comparaison à la vitesse ou à la durée de leur enregistrement réel.

6. Procédé selon l'une des revendications précédentes, **caractérisé en ce que** le test de fonctionnement est effectué après la fabrication du véhicule.

7. Procédé selon l'une des revendications 1 à 6, **caractérisé en ce que** le test de fonctionnement est effectué plusieurs fois durant l'assemblage du véhicule.

8. Procédé selon la revendication 7, **caractérisé en ce que**, dans le cadre de chaque test de fonctionnement, toutes les données réelles sont fournies sur le bus de communication.

9. Procédé selon l'une des revendications précédentes, **caractérisé en ce que** pour la fourniture des données réelles et pour l'enregistrement des données de réaction est employé un appareil de traitement de données mobile, portable qui est relié au bus de communication.

10. Procédé selon la revendication 9, **caractérisé en ce que** l'appareil de traitement de données reste dans le véhicule durant l'assemblage et enregistre de manière ordonnée toutes les données de réaction résultantes dans le cadre des tests de fonctionnement effectués durant ce temps.

11. Procédé selon la revendication 10, **caractérisé en ce que** les tests de fonctionnement sont effectués à des moments spécifiés à l'avance ou lorsqu'une phase d'assemblage prédéfinie est atteinte.

12. Procédé selon l'une des revendications précédentes, **caractérisé en ce que** les données réelles contiennent également des données de composants ou des composants en question qui ne sont pas intégrés au moins au moment des tests.

13. Procédé selon l'une des revendications précédentes, **caractérisé en ce que**, dans le cadre de l'enregistrement des données de réaction, également d'éventuelles entrées dans des mémoires d'erreur de composants, en particulier d'appareils de commande, sont extraites et enregistrées.

14. Procédé selon l'une des revendications précédentes, **caractérisé en ce que** le jeu de données réelles contient des données réelles relatives à un degré d'intégration maximal, spécifique au type, de composants électroniques et électriques.

15. Procédé selon l'une des revendications précédentes, **caractérisé en ce que**, dans l'appareil de traitement de données employé pour le test de fonctionnement, le cas échéant portable, sont déposés plusieurs jeux de données réelles, spécifiques de type, pour différents types de véhicules, le jeu de données réelles à employer étant sélectionné en fonction du véhicule à vérifier.

16. Procédé selon l'une des revendications précédentes, **caractérisé en ce que**, dans l'appareil de traitement de données employé pour le test de fonctionnement, le cas échéant portable, sont déposés plusieurs jeux de données réelles, spécifiques de type, pour différentes variantes d'équipement du véhicule, le jeu de données réelles à employer étant sélectionné en fonction du véhicule à vérifier.

17. Procédé selon l'une des revendications précédentes, **caractérisé en ce que**, dans l'appareil de traitement de données employé pour le test de fonctionnement, le cas échéant portable, sont déposés plusieurs jeux de données réelles, spécifiques au pays, le jeu de données réelles à employer étant sélectionné en fonction du véhicule à vérifier.

18. Procédé selon l'une des revendications 15 à 17, **caractérisé en ce que** la sélection du jeu de données se fait à l'aide d'une information, concernant les opérations de production du véhicule, indiquant le type de véhicule et le cas échéant la variante d'équipement et le cas échéant le pays de mise en circulation, ou à l'aide d'une information d'identification saisie ou fournie par le véhicule.

19. Procédé selon l'une des revendications 1 à 14, **caractérisé en ce que** le jeu de données réelles à employer pour le ou les tests de fonctionnement à effectuer est enregistré peu de temps avant dans l'appareil de traitement de données à employer.

20. Procédé selon l'une des revendications précédentes, **caractérisé en ce que** la comparaison des données mesurées aux données théoriques a lieu dans l'appareil de traitement de données même ou dans un dispositif informatique distinct auquel sont fournies les données mesurées enregistrées par l'appareil de traitement de données et, le cas échéant, les données théoriques.

21. Procédé selon l'une des revendications précédentes, **caractérisé en ce que**, à l'aide du résultat de la comparaison, un rapport de test est créé et sorti.

22. Dispositif pour tester des composants électriques ou électroniques intégrés dans un véhicule, configuré pour exécuter le procédé selon l'une des revendications 1 à 21.
